# EUROPEAN PATENT APPLICATION

(11) **EP 2 502 697 A1**
(43) Date of publication of application: **26.09.2012**
(21) Application number: 12159824.7
(22) Date of filing: 16.03.2012
(51) Int. Cl.: B23K 3/08, H01L 31/05, H01L 31/18

(54) **Device and method for applying welding flux to interconnection ribbons for photovoltaic cells**

(30) Priority: 23.03.2011 IT PD20110088
(71) Applicant: 2BG S.r.l., 35018 San Martino di Lupari (PD) (IT)
(72) Inventor: Bernadi, Dario, I-35010 Carmignano di Brenta, PADOVA (IT); Galiazzo, Antonio, I-35018 San Martino Di Lupari, PADOVA (IT); Guidolin, Javier, I-31050 Vedelago, TREVISO (IT)
(74) Representative: Mitola, Marco

(57) **Abstract**

The invention relates to a device for applying welding flux to interconnection ribbons for photovoltaic cells comprising: - an entrance 2 and an exit 3 for one or more interconnection ribbons; and - a first transit chamber 10 which is provided with means 20 for introducing the welding flux inside it and is located near the entrance 2. The first chamber 10 encloses within it two layers of spongy material 11,12, placed close to each other so as to define at their contact interface a first transit zone for rubbing 13 the ribbons coming from the entrance 2 and directed towards the exit 3. The flux, introduced into the first chamber 10 by the introduction means, impregnates both spongy layers and applies itself to the ribbons which, passing through the first transit zone 13 come into contact with the two spongy layers 11, 12. The present invention also relates to a method for applying welding flux to interconnection ribbons for photovoltaic cells.

## Description

### Field of application

The present invention relates to a device and a method for applying welding flux to interconnection ribbons for photovoltaic cells.

The device and the method according to the present invention fall within the sector of photovoltaic module production systems, in particular as relates to the stations for connecting the single cells in strings by means of metallic interconnection ribbons.

### State of the art

The connection of the single cells in strings is performed by means of metallic interconnection foils, known in the trade as "ribbons". Such ribbons, generally made from copper and coated in a thin film of a tin-based alloy, are welded to the cells to create a stable electric contact.

As is known, to enable the welding of such ribbons to the cells a special liquid flux, consisting of a conductive paste kept in suspension in a solvent, is applied to the ribbons.

Operatively, the flux is applied to the ribbons when the latter have already been applied to the cells for example by spraying, or preferably, is applied in a step prior to the joining of the ribbons to the cells to prevent the excess flux from depositing on said cells. In such latter case the flux may be applied to the ribbons again by spraying or by immersion, making the ribbons pass through flux baths.

As is known, the application of the flux to the ribbons before they are joined to the cells entails different operating complexities linked mainly to the fact that the flux applied in a liquid phase to the ribbons tends to get dispersed at least partially along the route of the ribbons, depositing itself in particular on the surfaces coming into contact with the ribbons, particularly the movement devices. The solid phase of the flux (following evaporation of the solvent) over time creates an accumulation of material which must be regularly removed. This imposes the temporary arrest of the plant and therefore an inevitable increase in downtime. Added to all this is the cost of the wasted flux.

In some solutions of the prior art the problem of dispersion of the flux has been tackled by envisaging a drying phase of the ribbons to let the solvent evaporate. Dying is induced after leaving the flux sufficient time to interact with the ribbons. In particular, the ribbon may be made to slide along an elongated route in a specific station of the plant where the ribbon subjected to prolonged contact with the air, optionally struck by a hot air flow, dries before being sent to the cells. However this solution, while considerably reducing the problem of dispersion of the flux, entails complications in terms of the plant and does not in any case reduce the amount of flux wasted.

### Presentation of the invention

Consequently, the purpose of the present invention is to overcome the drawbacks of the prior art mentioned above by making available a device and a method for applying welding flux to interconnection ribbons for photovoltaic cells which permits a controlled application of flux to the interconnection ribbons and therefore a reduction in the quantity of flux wasted in dispersion.

A further purpose of the present invention is to make available a device and a method for applying welding flux to interconnection ribbons for photovoltaic cells which at least partially permits the recovery of the excess flux applied to the interconnection ribbons.

A further purpose of the present invention is to make available a device for applying welding flux to interconnection ribbons for photovoltaic cells which permits an application of the flux in an operatively simple and efficient manner.

A further purpose of the present invention is to make available a device for applying welding flux to interconnection ribbons for photovoltaic cells which is easy and economical to produce.

### Brief description of the drawings

The technical characteristics of the invention, according to the aforementioned purposes, are clearly evident from the contents of the following claims and the advantages of the same will be clearer from the detailed description which follows, made with reference to the appended drawings, showing one or more embodiments by way of non-limiting examples, wherein

- Figure 1 shows a perspective view of a device for applying welding flux to interconnection ribbons for photovoltaic cells according to a preferred embodiment of the present invention;

- Figure 2 shows a perspective view of the device in Figure 1 with some parts removed so as to better illustrate others;

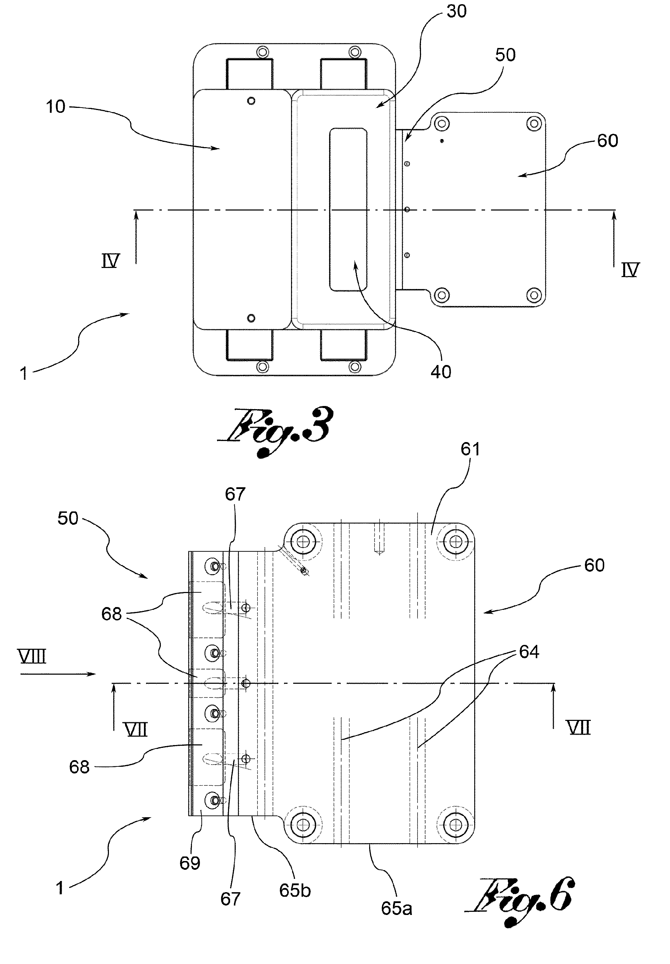

- Figure 3 shows a view from above of the device illustrated in Figure 1;

- figure 4 shows a cross-section view of the device in Figure 3 according to the cross-section plane IV therein indicated;

- Figure 5 shows an exploded view of a portion of the device in Figure 1 relative to the means for applying the flux and to the mechanical means for removing the excess flux;

- Figure 6 shows a view from above of another portion of the device in Figure 1 relative to drying means of the interconnection ribbons;

- figure 7 shows a cross-section lateral view of the drying means illustrated in Figure 6 according to the cross-section plane VII therein indicated;

- figure 8 shows a lateral front view of the drying means illustrated in Figure 6 according to the arrow VIII therein indicated;

- figure 9 shows a perspective front view of the drying means illustrated in Figure 6;

- figure 10 shows an exploded perspective view of the drying means illustrated in Figure 6;

- Figure 11 shows a view in elevation of the entrance area of the interconnection ribbons in the device illustrated in Figure 1 according to the arrow XI therein indicated;

- Figure 12 shows a view in elevation of the device illustrated in Figure 1 as indicated by the arrow XII, where the drying means have been removed so as to illustrate the exit zone of the interconnection ribbons from the mechanical removal means of the excess flux; and

- Figure 13 shows a schematic view of a device according to one embodiment of the invention provided with a flux recirculation circuit.

### Detailed description

With reference to the appended drawings, reference numeral 1 globally denotes a system a device for applying welding flux to interconnection ribbons for photovoltaic cells according to the invention.

According to a general embodiment of the invention, the device for applying welding flux to interconnection ribbons for photovoltaic cells comprises:

- an entrance 2 and an exit 3 for one or more interconnection ribbons; and

- a first transit chamber 10 which is provided with means 20 for introducing the welding flux inside it and is located near the entrance 2.

Such first chamber 10 encloses within it two layers of spongy material 11, 12, placed close to each other so as to define at their contact interface a first transit zone for rubbing 13 the ribbons coming from the entrance 2 and directed towards the exit 3.

Operatively, the flux is introduced into the first chamber 10 by means of the aforesaid introduction means, impregnates both spongy layers and applies itself to the ribbons which, passing through the first transit zone 13, come into contact with the two spongy layers 11, 12.

Thanks to the use of the aforesaid spongy layers 11 and 12 the flux can be applied to the ribbons in a controlled manner. In fact the spongy layers withhold the flux releasing it progressively as the ribbons pass through. The rubbing of the ribbons on the two spongy layers also has the effect of limiting the quantity of flux which, abandoning the spongy layers, is deposited on the main surfaces of the ribbons going to react with the superficial metallic material.

Preferably, the two spongy layers 11, 12 are laid over each other so that the contact interface is substantially coplanar with a horizontal movement plane p of the ribbons.

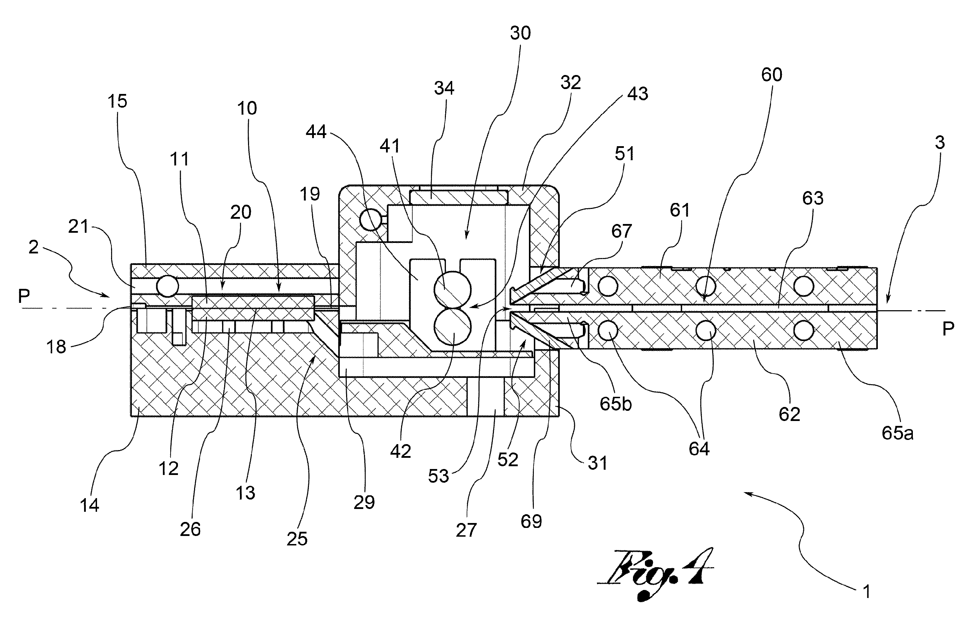

As may be seen in particular in Figure 4, a first layer 11, indicated henceforth as the upper layer, is positioned above the movement plane p, while the other layer, indicated henceforth as the lower layer 12, is positioned under the plane p.

In particular, the interconnection foils or ribbons are defined by thin strips on which two main opposite surfaces are defined. Operatively, the ribbons are moved in such a way that their main surfaces are parallel to the aforesaid movement plane p and therefore so that each of them comes into contact with one of the two spongy layers 11 and 12 laid on top of each other at the interface contact 13.

The flux introduction means 21 are placed above the upper spongy layer 11. Operatively, the flux reaches the lower layer 12 permeating through the upper layer 11. In particular, the flux tends to pass from the upper layer 11 to the lower layer 12 under the thrust of the flux which is preferably continually introduced in the first chamber 10, as will be described in more detail below.

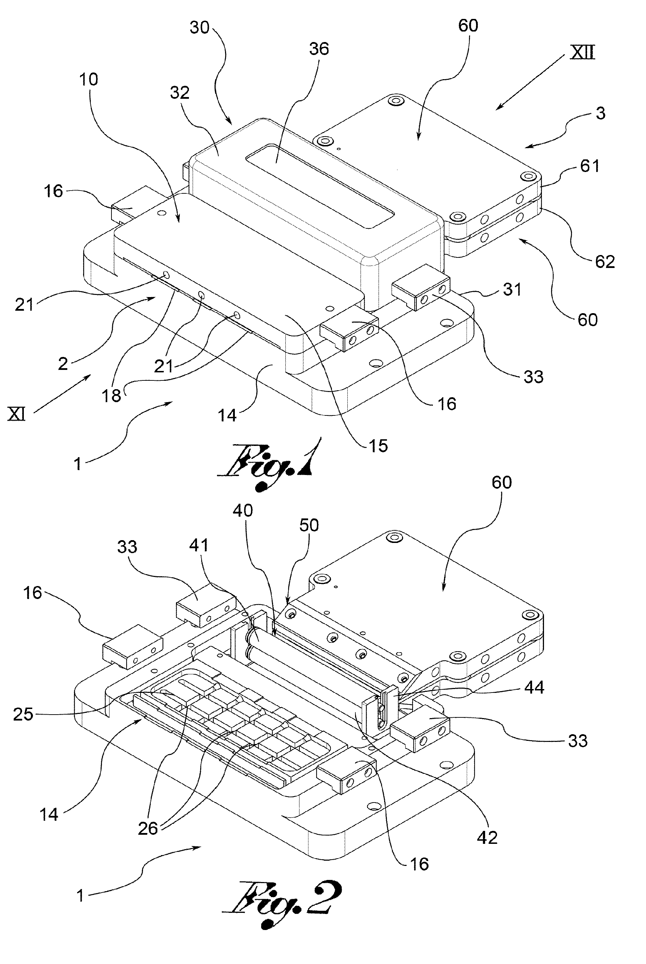

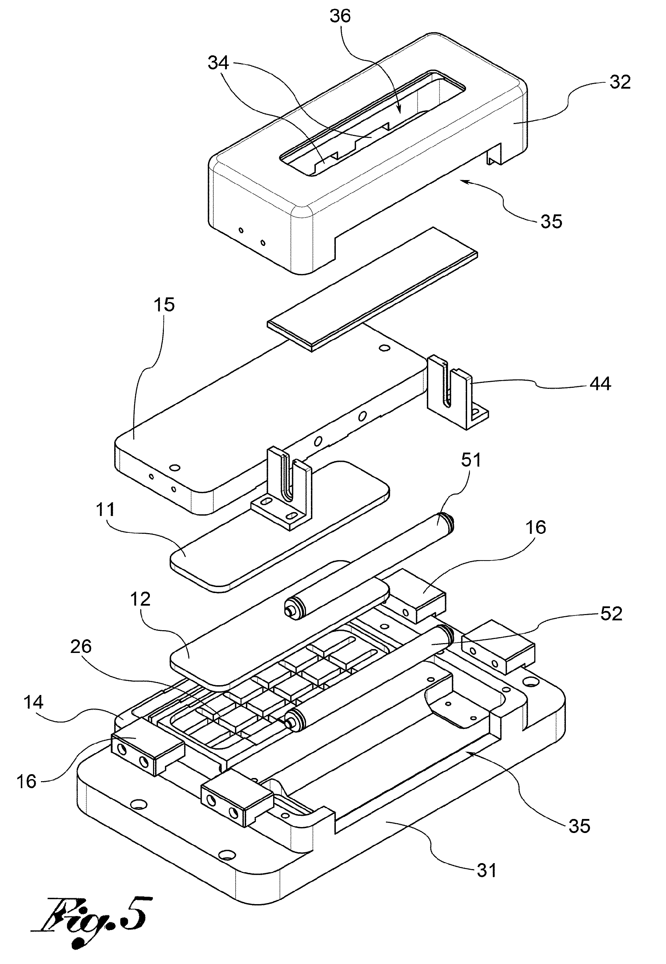

According to the embodiment illustrated in particular in figures 2 and 5, the first chamber 10 is defined by two shells, of which one defines the bottom 14 of the chamber and the other the lid 15. Preferably the lid 15 is removably connected to the bottom 14 by attachment means 16. The lower layer 12 is placed on the bottom 14, while the upper layer 11 is in turn placed on the lower layer 12. The two spongy layers 11 and 12 are held next to each other by the lid 15 closed on the bottom 14.

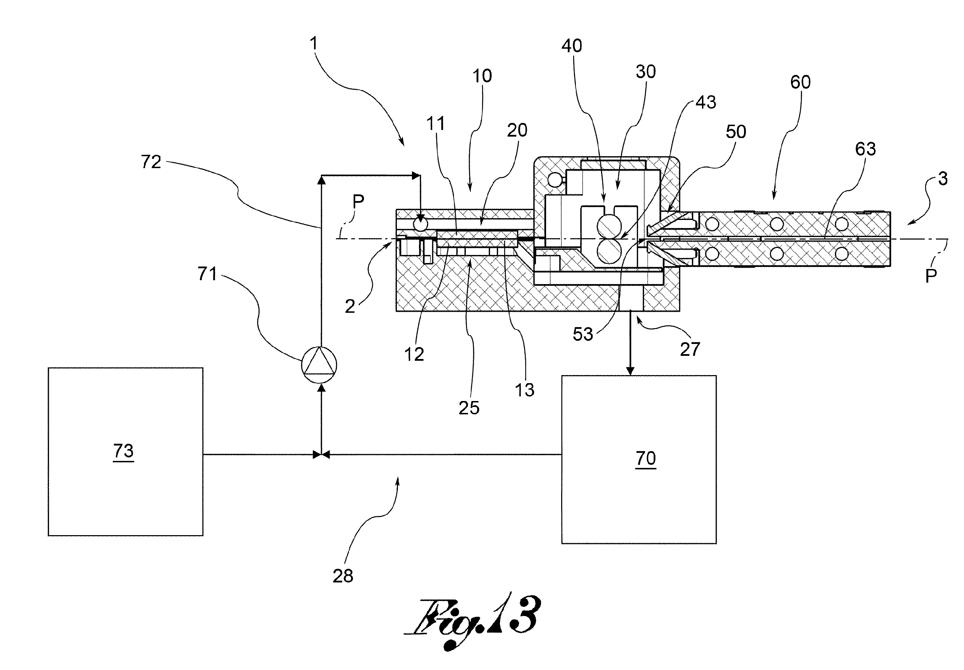

In particular, the introduction means 20 may consist of one or more channels (not shown in the appended figures), made inside the lid 15 and fluidically open to the inner chamber. Such channels can be connected through special apertures 21 to a flux supply circuit, as shown schematically in Figure 13.

As may be seen in particular in Figures 1, 2 and 11, in the area where the lid 15 abuts against the bottom 14, one or more first apertures 18 are made for the entrance of an equivalent number of ribbons inside the first chamber 10. Such first apertures 18 define the entrance 2 to the device 1. In an opposite position an equivalent number of second apertures 19 for the exit of the ribbons from the first chamber 10 are found.

In particular the first and second apertures 18 and 19 are coplanar to the movement plane p of the ribbons and to the interface surface 13 between the two spongy layers 11 and 12.

Advantageously, the device 1 comprises means 25 for collecting the flux permeating below the lower spongy layer 12.

According to a particularly preferred embodiment of the invention, such collection means comprise one or more channels 26, made on the bottom 14 of the first chamber 10 and fluidically connected to at least one drainage aperture 27. As may be seen in Figure 4, the channels 26 may be connected to the drainage aperture 27 by an inclined connection duct 29, which may extend below the second chamber 30.

In particular, as illustrated in Figure 2, the channels 26 may form a network which preferably extends all over the support surface of the lower spongy layer 12.

Advantageously, as illustrated schematically in Figure 13, the device 1 may comprise a recirculation circuit 28 of the flux collected under the lower spongy layer 12. Such circuit is fluidically connected to the aforementioned drainage aperture 27 and comprises in particular a flux collection tank, a movement pump 71 and at least one supply duct 72 fluidically connected to the introduction means 20 of the flux into the first chamber 10. The recirculation circuit 28 may advantageously be connected to a tank 73 of fresh flux.

Thanks to the presence of the flux collection means 25 the flux which is not applied to the ribbons can be recuperated. The recirculation circuit 28 also makes it possible to keep the flux continuously in circulation, facilitating its remixing and thereby avoiding unwanted sedimentation of the solid phase, which would detract from the efficacy of such flux. To such purpose the flux collection tank 70 may be provided with a stirrer (not shown in the appended figures).

Preferably, the device 1 comprises a second transit chamber 30, which is positioned downstream of the first chamber 10 and receives the ribbons leaving the first chamber. Such second chamber 30 contains inside it means for mechanically removing the flux which despite the presence of the spongy layers may have been applied in excess to the ribbons.

According to a preferred embodiment illustrated in the appended drawings, the aforesaid mechanical removal means comprise at least two swivelling rollers 41, 42 positioned so as to define between them a second transit area 43 for rubbing the ribbons. Operatively, the rollers 41, 42 remove in rotation at least part of the excess flux still present on the ribbons.

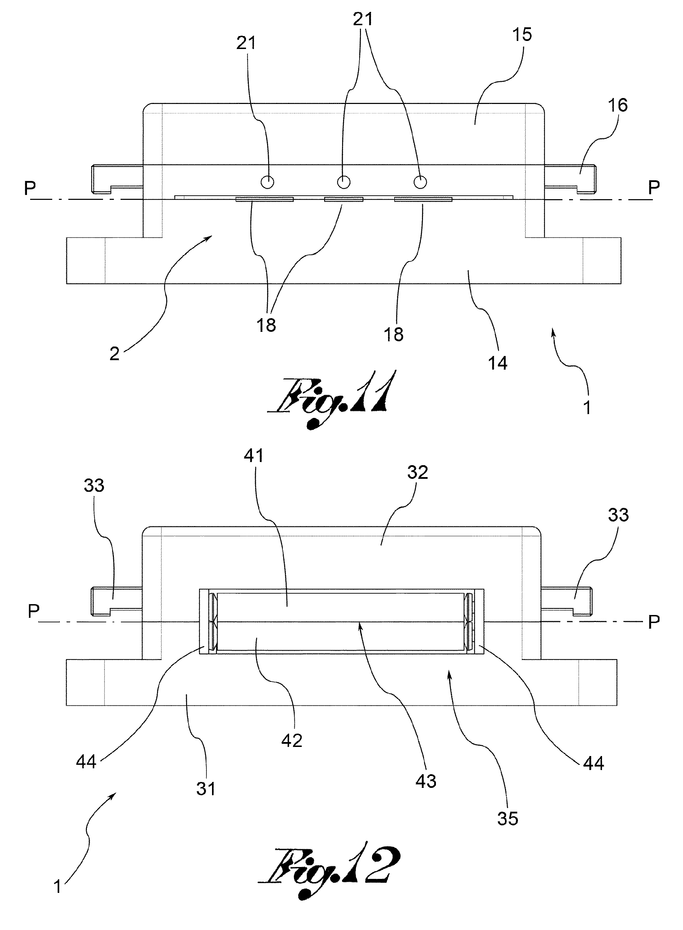

In particular, the rollers 41, 42 are supported at the ends by two forks 44 (as shown in figure 12). The rollers are preferably not motorised (though they may be motorised if necessary) and are dragged in rotation by the passage of the ribbons. Preferably the rollers 41 and 42 are made from steel.

More in detail, as may be seen in particular in Figure 5, the second chamber 30 is defined by two shells, of which one acts as a support base 31 (which in particular may be made in a single block with the bottom of the first chamber 10) and a second which defines a lid 32. Preferably the lid 32 is removably connected to the support base 31 by attachment means 33.

As may be seen in particular in Figures 4 and 5, first apertures 34 for the entrance of the ribbons coming from the first chamber 10 and second apertures 35 for the exit of the ribbons from the second chamber 30 are made in opposite positions on the lid 32.

Preferably, the aforesaid second apertures 35 create a single aperture which permits the connection of drying means 50, which will be described below.

Aspiration systems (not shown in the appended drawings) suitable for safely withdrawing the vapours of the solvent released by the flux, may be connected to the lid 32.

Advantageously, an observation window 36 may be made on the top of the lid 32, useful for observing in real time the movement of the ribbons at the point of the mechanical removal means and for assessing the need to clean the rollers.

In such regard, the functioning tests performed by the applicant of this patent application for long periods on the device 1 according to the invention have highlighted that cleaning operations are required after continued periods of functioning significantly longer than those of traditional devices.

Preferably, the device 1 comprises means for drying 50 the flux by air flows.

In particular, as may be seen in Figures 2 and 4, such drying means 50 are positioned downstream of the second transit chamber 30. Operatively, once the residues of flux present in excess on the ribbons have been removed by the mechanical means 41 and 42, the solvent present is made to evaporate so as to further reduce the soiling capacity of the residue still present.

Advantageously, the aforesaid drying means 50 by air flows comprise one or more air knife devices 51, 52.

According to a particularly preferred embodiment illustrated in the appended drawings, the aforesaid drying means 50 comprise at least two air knife devices 51, 52, distanced from each other so as to define a first passage interspace 53 for the ribbons and directed so as to generate converging flows towards the aforesaid first interspace 53. The generated air flows thereby strike both main sides of the ribbons.

As may be seen in particular in Figures 2 and 4, such air knife devices 51, 52 are connected at least partially inside the second chamber 30 at the second sole aperture 35 to introduce air flows on the ribbons inside the second chamber 30.

Preferably, the device 1 comprises a third transit chamber 60 which is positioned downstream of the second chamber 30 and is defined by two plates 61 and 62 , facing opposite each other and distanced to define a second passage interspace 63 for the ribbons coming from the entrance 2 of the device and directed towards the exit 3.

At least one of the plates 61, 62 is fitted with heating means 64, consisting for example of electric resistors. Preferably, the two plates 61, 62 are made from aluminium.

Advantageously, the aforesaid drying means 50 are positioned upstream of the third chamber 60 and are thermally associated to the two plates 51, 52 so as to enable heating of the jets of air generated by them and an increase of the drying capacity of the jets of air.

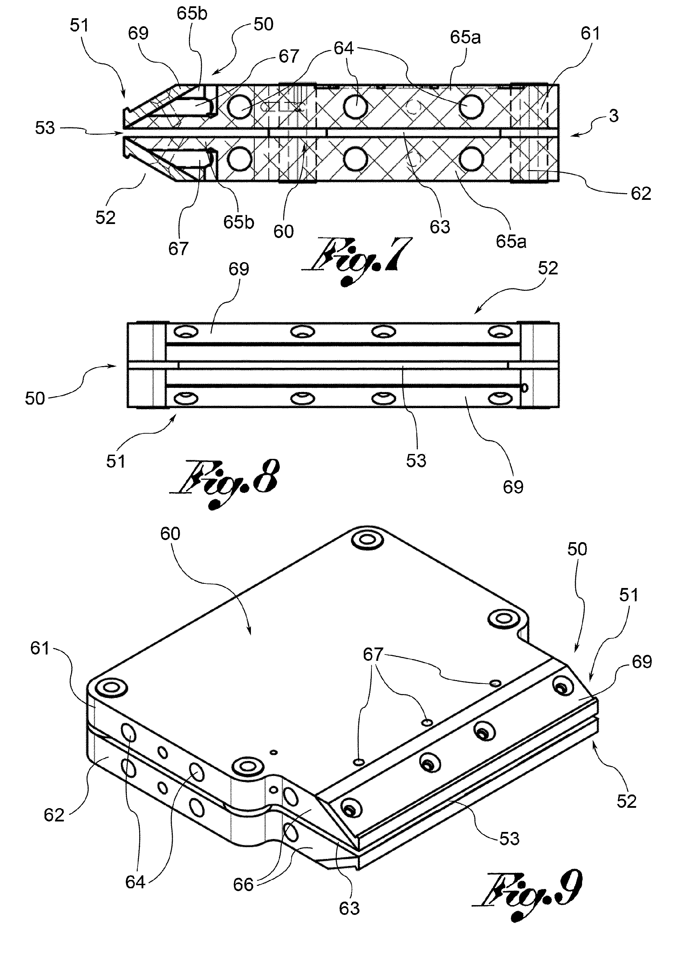

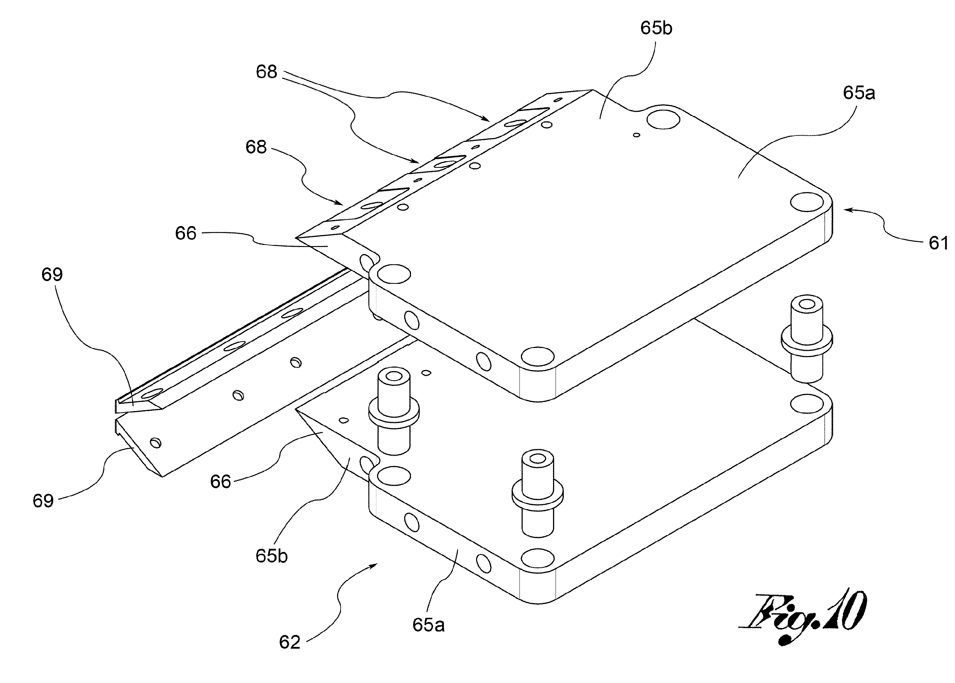

According to a particularly preferred embodiment illustrated in Figures 7 to 10, the air knife devices 51, 52 are directly incorporated onto the two opposite facing plates 61, 62.

More in detail, each plate 61, 62 comprises a main portion 65a, in relation to which the third chamber 60 is defined and at which the heating means 64 are positioned, and an appendix 65b, which is provided with a tapered end rim 66, inclined towards the side of the plate destined to face the other plate. One or more ducts 67 are made at such appendix 65b, which ducts may be connected to compressed air supplies and which come out on the tapered rim 66 at seats 68 lowered in relation to the surface of the tapered rim. A screen 69 is positioned on the tapered rim 68 which jointly defines with each lowered seat 68 an outflow air blade nozzle.

Advantageously, as may be seen in Figure 4, the two transit zones for rubbing 13 and 43 and the two passage interspaces 53 and 63 are substantially aligned with each other and coplanar with the movement plane p of the ribbons.

The present invention also relates to a method for applying welding flux to interconnection ribbons for photovoltaic cells.

The method according to the present invention may advantageously be implemented in particular in the device 1 described above.

In the description below the same reference numerals used for the description of the device will be used without by such wishing to limit the application of the present method to the device 1 described above.

In a general form of implementation the method according to the invention comprises the following operating steps:

- providing a) at least two layers of spongy material 11, 12 placed close to each other so as to define a contact interface;

- supplying b) welding flux to the two spongy layers 11,12;

- moving c) one or more interconnection ribbons between the two spongy layers 11,12 at the contact interface so as to apply flux to the surfaces of the ribbons.

As already said when describing the device, thanks to the use of the aforesaid spongy layers 11 and 12 the flux can be applied to the ribbons in a controlled manner. In fact the spongy layers withhold the flux releasing it progressively as the ribbons pass through. The rubbing of the ribbons on the two spongy layers also has the effect of limiting the quantity of flux which, abandoning the spongy layers, is deposited on the main surfaces of the ribbons going to react with the superficial metallic material.

Preferably, the ribbons are moved through the two spongy layers 11,12 with the respective main surfaces parallel to the contact interface of the two spongy layers.

According to a preferred implementation of the invention, in the providing step a) the two spongy layers 11, 12 are laid on top of each other. In the supply step b) the flux is supplied to the upper spongy layer 11 and reaches the lower layer 12 through the upper layer 11.

Again, according to such preferred form of implementation, the method comprises the following operating steps:

- a step d) of collecting the flux under the lower spongy layer 12; and

- a step e) of recirculating the flux collected, supplying it to the upper spongy layer.

As already said when describing the device, thanks to collection of the flux below, the flux which is not applied to the ribbons can be recuperated, reducing wastage. The recirculation of the flux also makes it possible to keep the flux continuously in circulation, facilitating its remixing and thereby avoiding unwanted sedimentation of the solid phase, which would detract from the efficacy of such flux.

With reference also to the device 1, the collection of the flux which abandons the spongy layers may also be implemented in the case in which the two spongy layers are not laid over each other horizontally, but are for example vertically alongside each other. In this case the flux is supplied to both the spongy layers and the collection of the flux is performed under both layers.

Advantageously, the method may comprise a step f) of mechanically removing the excess flux from the ribbons after the moving step c), preferably by contact with swivelling rollers.

The method may further comprise a step g) of drying the flux deposited on the ribbons after the removing step f), preferably by jets of air and/or by heating, so as to facilitate evaporation of the solvent. The soiling capacity of the flux remaining on the ribbons is thereby reduced.

The invention makes it possible to achieve numerous advantages, in part already described.

The device 1 and the method according to the invention permit a controlled application of flux to the interconnection ribbons, with a reduction in the quantity of flux wasted in dispersion.

Added to the controlled application of the flux is the mechanical removal of the excess flux. This also permits a reduction of the soiling phenomenon of the lines downstream of the application station of the flux to the ribbons, with benefits in terms of use of the plant and a reduction of downtime and servicing.

The device and the method according to the invention further permit an at least partial recovery of the flux applied in excess to the interconnection ribbons, with benefits in terms of savings in flux.

The device 1 permits an application of the flux in an operatively simple and efficacious manner, and is also easy and economical to produce.

The invention thus conceived thereby achieves the intended purposes.

Obviously, its practical embodiments may assume forms and configurations different from those described while remaining within the sphere of protection of the invention.

In addition, all the elements may be replaced with technically equivalent elements and the dimensions, shapes and material used may be varied as needed.

## Claims

1. Device for applying welding flux to interconnection ribbons for photovoltaic cells comprising:
- an entrance (2) and an exit (3) for one or more interconnection ribbons; and
- a first transit chamber (10) which is provided with means (20) for introducing the welding flux inside it and is located near the entrance (2) to said device (1), said first chamber (10) enclosing within it two layers of spongy material (11,12), placed close to each other so as to define at their contact interface a first transit zone for rubbing (13) said ribbons coming from said entrance (2) and directed towards said exit (3);
the flux, introduced into said first chamber (10) by said introduction means (20), impregnating both spongy layers and applying itself to the ribbons which, passing through the first transit zone (13), come into contact with the two spongy layers (11,12).

2. Device according to claim 1, wherein said two spongy layers (11,12) are laid over each other so that the contact interface is substantially coplanar with a horizontal movement plane (p) of said ribbons, an upper layer (11) being positioned above said plane (p) and a lower layer (12) being positioned under said plane (p), the introduction means (20) of the flux being positioned above said upper spongy layer (11) and the flux reaching the lower layer (12) through the upper layer (11).

3. Device according to claim 2, comprising means (25) for collecting the flux permeating below the lower spongy layer (12).

4. Device according to claim 3, wherein said means for collecting (25) comprise one or more channels (26) made on the bottom (14) of said first chamber (10) which said lower spongy layer (12) rests on and which are fluidically connected to at least one drainage aperture (27).

5. Device according to claim 4, comprising a recirculation circuit (28) of the flux fluidically connected to said drainage aperture (27) and to the introduction means (20) of the flux into the first chamber (10).

6. Device according to one or more of the previous claims, comprising a second transit chamber (30), positioned downstream of the first chamber (10) and containing inside it means for mechanically removing the excess flux on said ribbons.

7. Device according to claim 6, wherein said removal means comprise at least two swivelling rollers (41, 42) positioned so as to define between them a second transit area (43) for rubbing said ribbons, said rollers (41,42) removing in rotation at least part of the excess flux present on the ribbons.

8. Device according to one or more of the previous claims, comprising means for drying (50) the flux by air flows.

9. Device according to claims 6 and 8, wherein said drying means (50) are positioned downstream of the second transit chamber (30).

10. Device according to claim 8 or 9,wherein said drying means (50) comprise one or more air knife devices (51,52).

11. Device according to claim 10, wherein said drying means (50) comprise two air knife devices (51,52), distanced from each other so as to define a first passage interspace (53) for said ribbons and directed so as to generate converging flows towards said first interspace (53) so that the generated air flows strike both main sides of the ribbons.

12. Device according to one or more of the claims from 6 to 11, comprising a third transit chamber (60) which is positioned downstream of the second chamber (30) and is defined by two plates (61,62), facing opposite each other and distanced to define a passage interspace (63) for the ribbons coming from said entrance (2) and directed towards said exit (3), at least one of said plates (61,62) being provided with heating means (64).

13. Device according to claims 10 and 12, wherein said drying means (50) are positioned upstream of said third chamber (60) and are thermally associated to the two plates (51,52) so as to enable heating of the jets of air generated by them.

14. Method of applying welding flux to interconnection ribbons for photovoltaic cells comprising the following operating steps:
- providing a) at least two layers of spongy material (11,12) placed close to each other so as to define a contact interface ;
- supplying b) welding flux to said two spongy layers (11,12);
- moving c) one or more interconnection ribbons between the two spongy layers (11,12) at the contact interface so as to apply flux to the surfaces of said ribbons.

15. Method according to claim 14 wherein said ribbons are moved through said two spongy layers (11,12) with the respective main surfaces parallel to said contact interface.

16. Method according to claim 14 or 15, wherein in said providing step a) the two spongy layers (11, 12) are laid on top of each other, in said supply step b) the flux being supplied to the upper spongy layer (11) and reaching the lower layer (12) through the upper layer (11), said method comprising:
- a step d) of collecting the flux under the lower spongy layer (12); and
- a step e) of recirculating the flux collected, supplying it to the upper spongy layer.

17. Method according to one or more of the claims from 14 to 16, comprising a step f) of mechanically removing the excess flux from said ribbons after the moving step c), preferably by contact with swivelling rollers.

18. Method according to one or more of the claims from 14 to 17, comprising a step g) of drying the flux deposited on said ribbons after the removing step f), preferably by jets of air and/or by heating, so as to facilitate evaporation of the solvent.
